# EUROPEAN PATENT APPLICATION

(11) **EP 0 717 589 A2**
(43) Date of publication of application: **19.06.1996**
(21) Application number: 95308710.3
(22) Date of filing: 01.12.1995
(51) Int. Cl.: H05K 5/02, G06F 1/16

(54) **IC card unit**

(30) Priority: 15.12.1994 CA 2138303
(71) Applicant: International Business Machines Corporation, Armonk, N.Y. 10504 (US)
(72) Inventor: Kerklaan, Albert John, Milton, Ontario L9T 4Y5 (CA); Yeomans, Eric, Lindsay, Ontario K9V 5X3 (CA)
(74) Representative: Davies, Simon Robert

(57) **Abstract**

An IC card unit is easy to manufacture and can be fabricated with a thickness of greater than about 10.5 mm. The card is formed from two side covers. The first side cover 16 is formed generally as in Type I or Type II PCMIA IC cards. The second side 18 is formed as a base portion 20 having a centre raised portion 22. The raised portion can be formed for example from deep drawn stainless steel, cast magnesium, aluminum or zinc or molded plastic. When plastic is used to form the raised portion, it can be injection molded onto the base portion. The plastic raised portion can be metallized to provide for electrostatic shielding.

## Description

This invention relates to an IC (integrated circuit) card unit, and, in particular, an IC card and package suitable for use in computer equipment.

PCMCIA (Personal Computer Memory Card International Association) IC cards are known for use in computer equipment and are used to house the circuitry relating to, for example, memory and communication interfaces. According to PCMCIA standards, card thicknesses include the 3.3 mm Type I, 5 mm Type II, and 10.5 mm Type III. For use in the direct connection of communication lines to a communication interface card without the use of Data Access Arrangements, a stacked card slot has been employed having an internal height of greater than 10.5 mm which will accommodate a card having an increased thickness over Type III cards. Such a card can accommodate an input/output connector at an end of the card and has an increased internal volume over the known Type III cards which is of interest as card circuitry becomes more complex.

However, the packaging and assembly of the thicker cards poses problems since the thickness of the card often prevents the use of accepted packages and assembly methods known for the Type I to Type III cards. In addition, the thicker cards must be made to conform with accepted PCMCIA standards for resistance to, for example, torque, bend and drop, while being capable of fitting within the stacked card slots for which they are intended. The stacked slots which are provided in some lap top computers, such as those produced by Toshiba, have an internal height of about 18 mm and accommodate two 68 pin connectors. The connectors are located on the back wall of the slot in stacked relation to define an upper and lower connector. The centre point of the upper connector is approximately 2.5 mm below the upper limit of the slot while the lower connector is approximately 2.5 mm above the lower limit of the slot. Guides in the form of C-channels are provided for each of the upper and lower connectors and extend along the side walls of the slot to guide inserted cards into engagement with the connectors. To be compatible with the stacked slots, the edges of the card and the portion of the card adjacent the card connector must be maintained at a thickness of 3.3 mm and the card connector must be disposed on the front end of the card such that its centre point is not more than 2.5 mm above a face of the card. Since the card connector must be positioned to align with the connector in the computer slot, the thickness of the card can only be increased on one face of the card while the other face remains substantially flat.

Stainless steel is the preferred material for use in forming the portion of the package through which the card connector extends due to its optimal strength per weight and its electromagnetic shielding properties. Eight mil (0.2mm) stainless steel sheet is the heaviest allowable guage sheet metal for card packaging adjacent card connectors to maintain the required thickness of 3.3 mm. However, this sheet metal cannot be drawn out to form the extended covers of thicker cards without compromising the strength of the package beyond acceptable limits.

A package has previously been proposed which is stamped in one piece from sheet metal. The package is folded about a frame and is laser welded to seal it. The construction of the package is complicated and requires extensive handling. The appearance of the finished package has been found not to be acceptable.

Accordingly, the invention provides an IC card cover comprising: a hollow, raised portion and a base portion disposed about the raised portion.

In a preferred embodiment, the raised portion is formed from a material selected from the group comprising stainless steel, magnesium, aluminum, zinc and plastic. The raised portion may be attached to the base portion by means of a snap connection, wherein the snap connection comprises a groove formed about the raised portion which accepts a resilient flange formed on the base portion. Another possibility is that the raised portion is formed from plastic and is insert molded into engagement with the base portion.

The invention also provides an IC card outer shell comprising a first cover, and a second cover, comprising an IC card cover, as described above, attached to the first cover.

The invention further provides an IC card unit comprising such an IC card outer shell and circuitry and means associated therewith for external communication, wherein the first cover and the second cover encase the circuitry and provide an opening for exposure of a portion of the means for communication.

In a preferred embodiment, the IC card unit further comprises an input/output connector, the first cover and the second cover providing an opening for exposure of a portion of the connector.

Thus an IC card package has been provided which is easy to manufacture and which can be fabricated with a thickness greater than about 10.5 mm if desired. Such a card is capable of accommodating a full size input/output connector and can be adapted to provide electrostatic shielding.

Therefore, in accordance with a broad aspect of the present invention, there is provided an IC card package comprising: a first cover; and, a second cover comprising a hollow, raised portion and a base portion disposed about the raised portion, the second cover being attached to the first cover.

Further, in accordance with another broad aspect of the present invention, there is provided an IC card comprising: circuitry and means associated therewith for external communication; a first cover; and, a second cover comprising a hollow, raised portion and a base portion disposed about the raised portion, the first cover and the second cover encasing the circuitry and providing an opening for exposure of a portion of the means for communication.

Such an IC card and package may have a thickness of greater than about 10.5 mm, if desired, and is able to accommodate an input/output connector such as, for example, a jack for an RJ-type or 8-pin modular type plug.

In a preferred embodiment, the package comprises a first cover and a second cover. The first and second covers are attached by any suitable means such as, for example, pivotal connection, snap connections, adhesives, laser welding or resin filling. The attached cover portions provide encasement for circuitry and a means for external communication, such as, for example, a 68-pin card connector.

An end of the package, which will be defined, for convenience, as the front end, is formed to accommodate the card connector and to maintain the required thickness of the card adjacent the card connector. For example, when a 68-pin connector is used, the front end portion of the package is maintained at a thickness of 3.3 mm and has an opening through which a portion of the connector extends and is exposed for connection to the computer connector. In one embodiment, the opening for the connector is defined by front end portions of the first and second covers and these front end portions are formed from 8 mil (0.2mm) thick stainless steel.

In a preferred embodiment, the first cover extends rearwardly from the card connector and is substantially planar, or alternatively, substantially planar about its periphery with a central dished portion of about 1 mm in height. Thus, the first cover maintains the orientation of the card connector for insertion into a corresponding connector within a card slot. The first cover is formed of materials which provide strength to the package and conform to the standards accepted for PCMCIA cards. Preferably, the first cover is formed as one piece from 8 mil (0.2mm) stainless steel.

The first cover is adapted for attachment to the second cover. The second cover comprises a hollow, raised portion, which increases the internal volume and the thickness of the package and a substantially planar base portion disposed about the periphery of the raised portion. To maximize the internal volume of the package the raised portion may be formed to accommodate substantially the full face of the card except those portions adjacent the front and sides of the card which must be maintained at a thickness which permits insertion into the slot guides and computer connector. Preferably, the base portion has an outline which corresponds to known Type I to Type III cards and known assembly methods and machinery for bonding the covers and for mounting the covers to the assembly are used for producing the cards.

The base portion is formed of any materials which provide strength to the package and conform to the PCMCIA standards. Preferably, the base portion is formed as one piece using the same material as is used for the front end portion adjacent the connector, such as maximum 8 mil (0.2mm) stainless steel.

The raised portion is also constructed to conform to the PCMCIA standards relating to strength etc. and is formed of a suitable material. Preferably, the raised portion is formed as a one piece design such as by deep drawing stainless steel, casting aluminum, zinc or magnesium or molding plastic, such as polycarbonate.

The raised portion is attached to the base portion by any suitable means such as by laser welding, adhesives, snap connections or insert molding. In one embodiment, an integral latch is provided between the base portion and the raised portion. By use of the integral latch, the raised portion is snapped to the base portion by force, or alternatively, when the raised portion is formed of plastic, the raised portion is insert molded into engagement with the base portion.

Where a package having electrostatic discharge properties is required, a ground contact is placed between the cover and the internal circuitry. In packages having a raised portion formed of plastic, the plastic can be metallized such as by internal plating with a conductive metal, such as nickel, and the plated metal layer suitably grounded.

The increased thickness of the present package provides a means for mounting a standard input/output connector, such as an RJ-type connector, within the card package. The package is made to accommodate and allow exposure of the connector for insertion of a plug.

The package of the present invention provides a simple method of assembly for a card. Such method first comprises assembly of the second cover by attachment of the raised portion to the base portion. The second cover is then assembled with the circuitry and the first cover by any suitable means such as by adhesives, resin filling, snap connections or laser welding. In one embodiment, the first and second covers are mounted on a support frame which provides drop resistance to the package.

Embodiments of the invention will now be described by way of example only, with reference to the following drawings:
FIGURE 1 shows a perspective view of an IC card unit in accordance with the present invention;
FIGURE 2 shows a sectional view of an IC card package taken along line 2-2 of Figure 1;
FIGURE 3 shows a sectional view of another embodiment of the IC card unit in accordance with the present invention;
FIGURE 4 shows a sectional view of another embodiment of the IC card unit in accordance with the present invention; and
FIGURE 5 shows a perspective view of another embodiment of the IC card unit in accordance with the present invention.

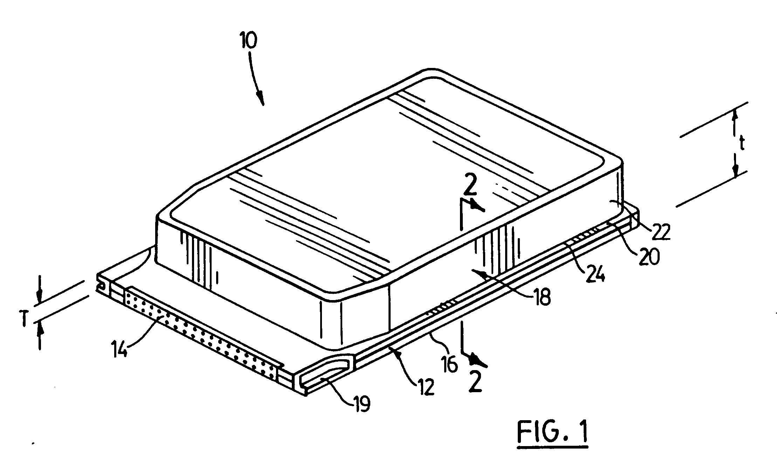

Referring to Figure 1, an IC card 10 is shown comprising a package 12 capable of being formed to have an thickness, indicated at t, which is greater than that of Type III PCMCIA cards such as greater than 10.5 mm. The package accommodates an internal circuit board (not shown) and a 68-pin card connector 14, exposed at the front end of the package.

Package 12 comprises a first cover 16 and a second cover 18, including raised portion 22 and base portion 20, disposed about the periphery of raised portion 22 and attached to raised portion 22 at 24. First cover 16 and base portion 20 of second cover 18 define an opening adjacent the front end of the package through which connector 14 extends and is exposed for connection to a computer (not shown). The thickness, indicated at T, of the front end of the package as defined by portions of members 16 and 20 is 3.3 mm which conforms with the PCMCIA standard for connector size. First cover 16 and base portion 20 of second cover 18 are formed of suitable materials, such as 8 mil (0.2mm) stainless steel, which provide sufficient strength for rigidity while maintaining the required thickness.

First cover 16 is substantially planar and extends back from connector 14, as does base portion 20 of second cover 18. First cover 16 and second cover 18 are mounted on a plastic frame 19 which is exposed at each corner of the card to provide impact resistance.

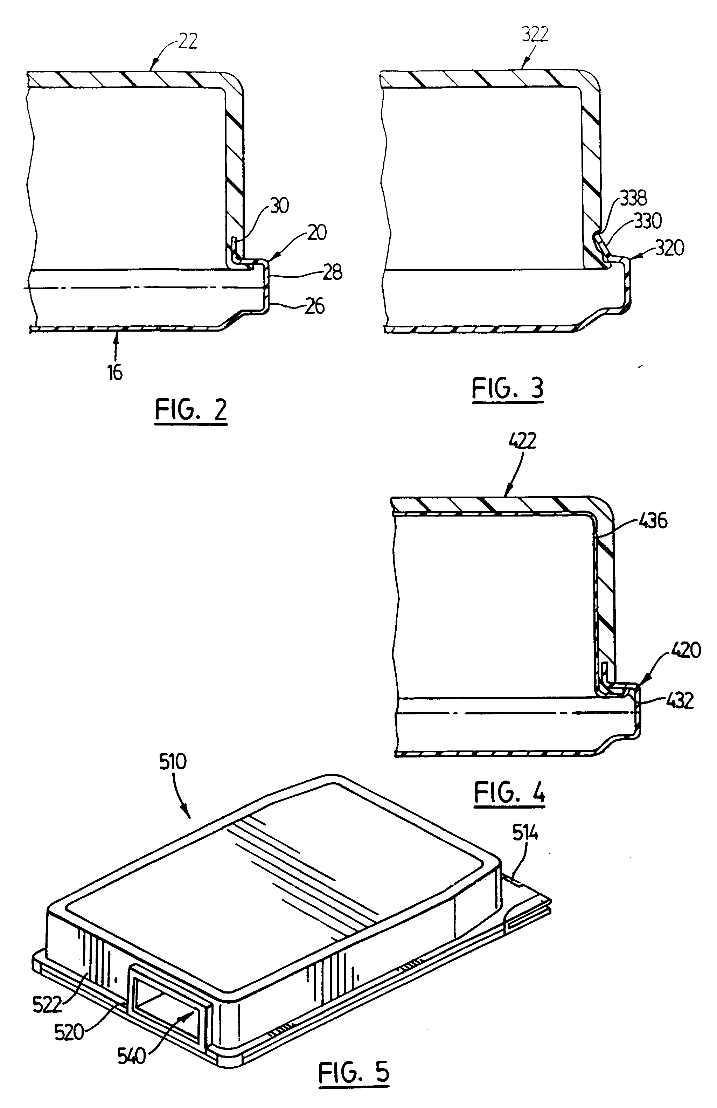

Referring to Figure 2, first cover 16 is formed with inwardly turned edges 26 which abut with corresponding inwardly turned outer edges 28 of base portion 20. Edges 26, 28 provide protection for the sides of the card and enhance the resistance of the card to bending.

In an embodiment as shown in Figure 2, raised portion 22 is formed of plastic and is insert molded into engagement with base portion 20. Such a connection acts to seal against the passage of dust and debris. By means of insert molding, raised portion 22 is molded into engagement with an upturned flange 30 formed on and extending about the inner edges of base portion 20.

In another embodiment, as shown in Figure 3, raised portion 322 is positioned into engagement with base portion 320 by means of a snap-together lock arrangement. In such an arrangement, a groove 338 is formed about the outer edge of raised portion 322. The inner edges of base portion 320 are formed to define an upturned flange 330 which corresponds to groove 338 on raised portion 322. To assemble the first cover, raised portion 322 is inserted into the opening of base portion 320 and flange 330 is forced into groove 338.

Referring to Figure 4, in an embodiment in which it is required that the package comprise electrostatic shielding properties and the raised portion is formed of non-conductive material such as plastic, a layer of conductive metal 436, such as nickel, is applied to the inner surfaces of raised portion 422 and is in contact, such as by solder bead 432, with the conductive metal of base portion 420 which is grounded. Alternatively, the conductive layer is connected directly to a ground contact.

Referring to Figure 5, an IC card 510 is shown having a back portion, opposite connector 514, adapted to accommodate an input/output connector 540. Raised portion 522 and base portion 520 are cut away to form a opening through which a portion of connector 540 can extend to accept a plug (not shown).

## Claims

1. An IC card cover (18) comprising:
a hollow, raised portion (22) and a base portion (20) disposed about the raised portion.

2. The cover of claim 1 wherein the raised portion is formed from a material selected from the group comprising stainless steel, magnesium, aluminum, zinc and plastic.

3. The cover of claim 1 or 2 wherein the raised portion is attached to the base portion by means of snap connection.

4. The cover of claim 3 wherein the snap connection comprises a groove formed about the raised portion which accepts a resilient flange formed on the base portion.

5. The cover of claim 2 wherein the raised portion is formed from plastic and is insert molded into engagement with the base portion.

6. The cover of any of claims 1 to 4 wherein the raised portion is metallized.

7. An IC card outer shell comprising:
a first cover (16); and
a second cover, comprising an IC card cover as claimed in any preceding claim, attached to the first cover.

8. An IC card unit (12) comprising an IC card outer shell as claimed in claim 7; and circuitry and means associated therewith for external communication, wherein the first cover and the second cover encase the circuitry and provide an opening for exposure of a portion of the means for communication.

9. The IC card unit of claim 8 further comprising an input/output connector, the first cover and the second cover providing an opening for exposure of a portion of the connector.
